# EUROPEAN PATENT SPECIFICATION

(11) **EP 3 125 300 B1**
(45) Date of publication and mention of the grant of the patent: **12.12.2018**
(21) Application number: 15768486.1
(22) Date of filing: 23.02.2015
(51) Int. Cl.: H01L 31/0224, H01L 31/05

(54) **SOLAR CELL AND SOLAR CELL MODULE USING SAME**
SOLARZELLE UND SOLARZELLENMODUL DAMIT
PILE PHOTOVOLTAÏQUE ET MODULE PHOTOVOLTAÏQUE L'UTILISANT

(30) Priority: 27.03.2014 JP 2014066030
(43) Date of publication of application: 01.02.2017
(73) Proprietor: KYOCERA Corporation, Kyoto 612-8501 (JP)
(72) Inventor: ARIMA, Takahiro, Kyoto-shi Kyoto 612-8501 (JP); ITO, Norikazu, Kyoto-shi Kyoto 612-8501 (JP); HONMA, Takemichi, Kyoto-shi Kyoto 612-8501 (JP)
(74) Representative: Viering, Jentschura & Partner mbB Patent- und Rechtsanwälte
(86) International application number: PCT/JP2015/055008
(87) International publication number: WO 2015/146413

(56) References cited:
- EP-A2- 1 811 576
- EP-A2- 2 511 957
- WO-A1-2013/039158
- WO-A1-2013/039158
- WO-A2-2013/090562
- JP-A- H09 135 035
- JP-A- 2007 287 861
- JP-A- 2010 272 725
- JP-A- 2011 009 459

## Description

### Technical Field

The present invention relates to a solar cell included in a solar cell module.

### Background Art

Solar cell modules each include a plurality of solar cell elements electrically connected together, the solar cell elements including, for example, silicon semiconductor substrates. In Japanese Unexamined Patent Application Publication No. 2006-278695, a plurality of solar cell elements are connected together by using lead members (connection tabs).
Document EP 1 811 576 A2 discloses a tab electrode for electrically connecting a plurality of photovoltaic elements, in which the tab electrode is electrically connected to the finger electrode in a region corresponding to a power generation region of the photovoltaic element and bonded on the light receiving surface through an insulating bonding material. Document WO 2013/090562 A2 discloses a photovoltaic cell comprising a silicon base substrate and including an upper doped region. A dielectric coating layer is disposed on the upper doped region and has an outer surface. Fingers are disposed in the coating layer. A busbar is spaced from the upper doped region and is in electrical contact with the upper portions of the fingers.

Regarding the connection between the solar cell elements, the lead members and electrodes of the solar cell elements are connected by using solder. Thus, solder fillets can be formed at both ends of each of the lead members in the width direction.

In solar cell modules, stresses are easily generated because of differences in thermal expansion coefficient between semiconductor substrates and the lead members. The stresses are liable to concentrate on the solder fillets. Thus, when large fillets are formed, cracks can be formed at electrode portions directly below end portions of the fillets.

### Citation List

### Patent Literature

PTL 1: Japanese Unexamined Patent Application Publication No. 2006-278695

### Summary of Invention

### Technical Problem

There are provided a high-reliability solar cell and a solar cell module.

### Solution to Problem

The present invention provides a solar cell according to claim 1 and a solar cell module according to claim 9. Further embodiments of the present invention are described in the dependent claims.

### Advantageous Effects of Invention

According to the embodiment of the present invention, the formation of fillets is inhibited to reduce stresses. This enhances the reliability of the solar cell and the solar cell module.

### Brief Description of Drawings

Fig. 1 is a schematic plan view of a solar cell element included in a solar cell according to an embodiment of the present invention when viewed from the side of a light-receiving surface.
Fig. 2 is a schematic plan view of a solar cell element included in a solar cell according to an embodiment of the present invention when viewed from a back side.
Fig. 3 schematically illustrates the structure of a solar cell element included in a solar cell according to an embodiment of the present invention and is a schematic cross-sectional view taken along line K-K of Fig. 2.
Fig. 4(a) is a schematic plan view of a solar cell according to an embodiment of the present invention, and Fig. 4(b) is a schematic cross-sectional view illustrating a state of the connection between two solar cells.
Fig. 5 illustrates a state of a solar cell when no spacer member is arranged in spaces between first electrodes, Fig. 5(a) is an enlarged schematic plan view of a first electrode and its neighborhood, Fig. 5(b) is a schematic cross-sectional view taken along line Y1-Y1 of Fig. 5(a), and Fig. 5(c) is a cross-sectional view taken along line X1-X1 of Fig. 5(a).
Fig. 6 illustrates a state of a solar cell when spacers are arranged spaces between first electrodes, Fig. 6(a) is an enlarged schematic plan view of a first electrode, a spacer, and their neighborhood, Fig. 6(b) is a cross-sectional view taken along line Y2-Y2 of Fig. 6(a), and Fig. 6(c) is a cross-sectional view taken along line X2-X2 of Fig. 6 (a) .
Fig. 7 is a schematic cross-sectional view of a portion of a solar cell element included in another solar cell according to the present invention, the portion corresponding to line X2-X2 of Fig. 6(a).
Fig. 8 is an enlarged schematic plan view of portion A of Fig. 2.
Fig. 9 is a schematic cross-sectional view taken along line Z-Z of Fig. 8, Fig. 9(a) illustrates a structure in which a spacer member do not intersect with a fourth electrode, and Fig. 9(b) illustrates a structure in which a portion of a spacer member is located on the fourth electrode.
Fig. 10 is a schematic cross-sectional view of a solar cell element of a solar cell according to another embodiment of the present invention when viewed from a back side.
Figs. 11(a) to 11(g) are schematic cross-sectional views illustrating production steps of a solar cell according to an embodiment of the present invention.
Fig. 12(a) is a schematic plan view illustrating a first surface side of a solar cell module including solar cells according to an embodiment of the present invention, and Fig. 12(b) is a schematic plan view illustrating a second surface side according to an embodiment.
Fig. 13 is a schematic cross-sectional view illustrating the structure of a solar cell panel including a solar cell module according to an embodiment of the present invention.

### Description of Embodiments

A solar cell according to an embodiment of the present invention will be described below with reference to the drawings. In the following description, a solar cell that is not provided with a lead member is referred to as a "solar cell element". A solar cell module refers to a module in which a plurality of solar cells (a plurality of solar cell elements) are electrically connected together. Components which are included in solar cell elements, solar cells, and solar cell modules and which have the same names are designated using the same reference numerals.

### <Solar cell element and solar cell>

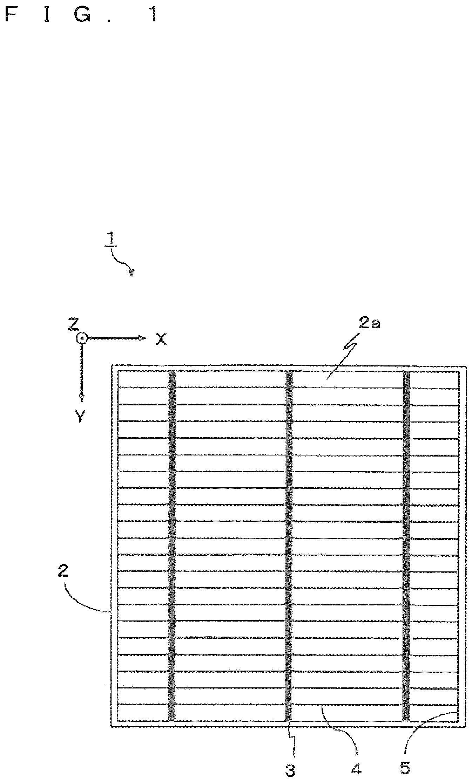

As illustrated in Figs. 1 to 3, a solar cell element 1 includes a semiconductor substrate 2. The semiconductor substrate 2 includes a light-receiving surface 2a that mainly receives incident light and a back surface 2b located on the backside of the light-receiving surface 2a. The solar cell element 1 includes light-receiving-surface-side electrodes on the light-receiving surface 2a. The solar cell element 1 includes back-surface-side electrodes on the back surface 2b.

The semiconductor substrate 2 includes a first semiconductor portion 2p having a first conductivity type (for example, p-type) and a second semiconductor portion 2n having a second conductivity type (for example, n-type). The second semiconductor portion 2n is located on the first semiconductor portion 2p. For the semiconductor substrate 2, a p-type silicon substrate containing a predetermined dopant element, for example, boron or gallium, is used. The silicon substrate may be monocrystalline or polycrystalline. The semiconductor substrate 2 may have a thickness of, for example, about 100 to about 250 µm. The shape of the semiconductor substrate may be a quadrangle, for example, a square or rectangle, with a side having a length of about 150 to about 180 mm.

The second semiconductor portion 2n is located on the side of the light-receiving surface 2a of the semiconductor substrate 2. When the first semiconductor portion 2p has p-type conductivity, the second semiconductor portion 2n has n-type conductivity. The second semiconductor portion 2n having n-type conductivity may be formed by, for example, diffusion of a dopant element, such as phosphorus, into a portion of the semiconductor substrate 2 having p-type conductivity, the portion of the semiconductor substrate 2 being adjacent to the light-receiving surface 2a.

An antireflection film 13 is arranged on the light-receiving surface 2a of the semiconductor substrate 2. The antireflection film 13 reduces the light reflectance of the light-receiving surface 2a to increase the amount of light absorbed by the semiconductor substrate 2. This improves the photoelectric conversion efficiency of the solar cell element 1. The antireflection film 13 is formed of, for example, a nitride film, such as a silicon nitride film; or an oxide film, e.g., a titanium oxide film, a silicon oxide film, or an aluminum oxide film. The antireflection film 13 may be formed of a stack of the nitride film and the oxide film. The thickness and so forth of the antireflection film 13 are appropriately optimized, depending on the material thereof. For example, the antireflection film 13 may have a refractive index of about 1.8 to about 2.3 and a thickness of about 30 to about 120 nm.

The light-receiving-surface-side electrodes are arranged on the second semiconductor portion 2n as illustrated in Fig. 1. The light-receiving-surface-side electrodes include busbar electrodes 3 and collector electrodes 4. One or both end portions of each of the collector electrodes 4 are connected to the corresponding busbar electrodes 3. The solar cell element 1 may include auxiliary collector electrodes 5 configured to be connected to outer end portions of the collector electrodes 4.

The busbar electrodes 3 on the light-receiving surface 2a are to be connected to lead members 15 in a module production process described below. Each of the busbar electrodes 3 is in the form of, for example, a strip. For example, about 2 to about 4 busbar electrodes 3 each having a width of about 1 to about 3 mm are arranged in a first direction (the Y direction in Fig. 1). The collector electrodes 4 and the auxiliary collector electrodes 5 collect photogenerated carriers. Each of the collector electrodes 4 has a width of about 50 to about 200 µm. The plurality of the collector electrodes 4 are arranged at intervals of about 1 to about 3 mm with respect to one another and intersect substantially orthogonally with the busbar electrodes 3. Each of the auxiliary collector electrodes 5 may have a width of about 50 to about 200 µm.

Electrodes, such as the busbar electrodes 3, the collector electrodes 4, and the auxiliary collector electrodes 5, may have a thickness of about 10 to about 25 µm. These electrodes may be composed of at least one metal selected from silver and copper as a main component. These electrodes may be formed by the application of a conductive paste containing the metal, a glass frit, an organic vehicle, and so forth using, for example, screen printing and then firing.

A passivation layer 6 is arranged on the back surface 2b of the semiconductor substrate 2. The passivation layer 6 has the effect of reducing the recombination of minority carriers on the side of the back surface 2b of the semiconductor substrate 2. This improves the photoelectric conversion efficiency of the solar cell element 1. The passivation layer 6 may be composed of, for example, silicon nitride, silicon oxide, titanium oxide, or aluminum oxide. The passivation layer 6 may have a thickness of, for example, about 10 to about 200 nm. The passivation layer 6 may be formed by, for example, an atomic layer deposition (ALD) method, a plasma-enhanced chemical vapor deposition (PECVD) method, a thermal CVD method, an evaporation method, or a sputtering method. The passivation layer 6 may be arranged on the light-receiving surface 2a and a side surface of the semiconductor substrate 2.

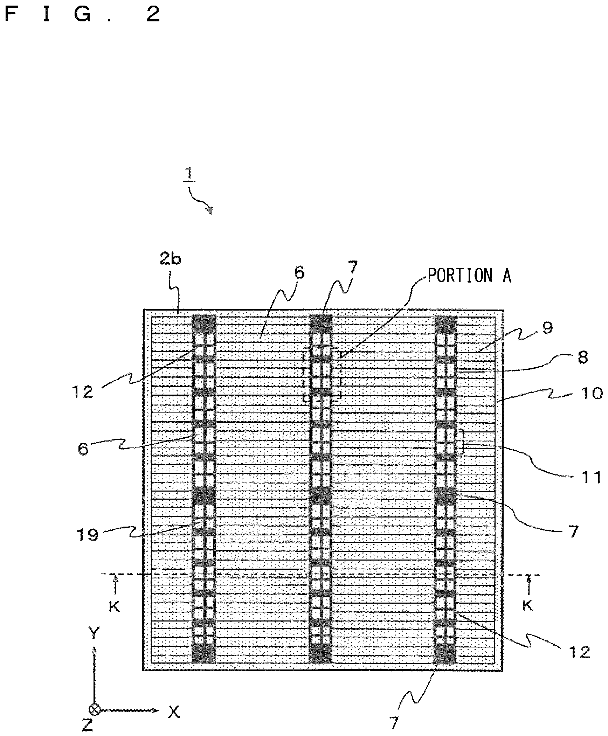

As illustrated in Fig. 2, the back-surface-side electrodes include first electrodes 7, second electrodes 8, third electrodes 9, and auxiliary collector electrodes 10 on the back surface 2b of the semiconductor substrate 2. Some back-surface-side electrodes may be arranged on the passivation layer 6.

The first electrodes 7 are to be connected to the lead members in the module production process described below. Each of the first electrodes 7 includes a surface, side surfaces, and a back surface. The lead members are connected to the surfaces of the first electrodes 7. The first electrodes 7 are arranged on the back surface 2b (main surface) in the first direction (the Y direction in Fig. 2). About 5 to about 20 pieces of the first electrodes 7 are arranged in a line in the first direction with a space 11 kept therebetween. The first electrodes 7 arranged in a line are located directly below the busbar electrodes 3. Each of the first electrodes 7 may have a size of, for example, about 3 to about 10 mm in the width direction (X direction), about 1 to about 8 mm in the longitudinal direction (Y direction), and about 2 to about 12 µm in thickness. The first electrodes 7 may be formed by, for example, the same screen printing method as in the light-receiving-surface-side electrodes.

The passivation layer 6 is arranged on portions of the main surface of the semiconductor substrate 2 at which the spaces 11 each between neighboring two of the first electrodes 7 are located. This improves the photoelectric conversion efficiency of the solar cell element 1.

The second electrodes 8 are arranged on the main surface of the semiconductor substrate 2 in the first direction (Y direction). The second electrodes 8 are arranged so as to connect the side surfaces of neighboring two of the first electrodes 7 together. As illustrated in Fig. 2, two second electrodes 8 may be arranged in the Y direction so as to be paired. In this case, the second electrodes 8 are arranged along two sides of the first electrodes 7 and connected to the side surfaces of the first electrodes 7. The second electrodes 8 assist the conduction of photogenerated carriers to the first electrodes 7, the photogenerated carriers being collected by the third electrodes 9. The arrangement of the second electrodes 8 permits the first electrodes 7 to have a pattern with the spaces 11 instead of a strip pattern. In this structure, the passivation layer 6 may be arranged in the spaces 11, thus improving the photoelectric conversion efficiency of the solar cell element 1. Each of the second electrodes 8 may have, for example, a linear form with a line width of about 0.5 to about 3 mm and a thickness of about 30 to about 60 µm.

The third electrodes 9 are arranged on the main surface of the semiconductor substrate 2 other than the spaces 11. The third electrodes 9 are connected to the second electrodes 8 and extend outward from the second electrodes 8 in a direction crossing the Y direction. For example, as illustrated in Fig. 2, the third electrodes 9 are arranged in the X direction. The third electrodes 9 collect photogenerated carriers. The third electrodes 9 may have a strip shape with a line width of about 100 to about 500 µm and a thickness of about 15 to about 40 µm. The plural third electrodes 9 are arranged at intervals of about 1 to about 6 mm with respect to one another. One or both end portions of each of the third electrodes 9 are connected so as to intersect with the second electrodes 8.

As illustrated in Fig. 2, each of the auxiliary collector electrodes 10 electrically connects end portions of the third electrodes 9 together, the end portions being located on a corresponding one of the end portion sides of the solar cell element 1. Thus, the auxiliary collector electrodes 10 are arranged in the Y direction. For example, each of the auxiliary collector electrodes 10 may have a line width of about 100 to about 300 µm and a thickness of about 15 to about 40 µm. The third electrodes 9 and the auxiliary collector electrodes 10 contain aluminum as a main component. The third electrodes 9 and the auxiliary collector electrodes 10 may be formed by, for example, the application of a conductive paste containing aluminum, a glass frit, an organic vehicle, and so forth using screen printing or the like and then firing.

The second electrodes 8, the third electrodes 9, and the auxiliary collector electrodes 10 may be composed of the same material. In this case, these electrodes may be formed in the same step, leading to the simplification of the process. The second electrodes 8, the third electrodes 9, and the auxiliary collector electrodes 10 contain aluminum as a main component; hence, back surface field (BSF) layers 14 containing high concentrations of aluminum diffused in inner portions of the semiconductor substrate 2 corresponding to positions of these electrodes are simultaneously formed.

Each of the second electrodes 8 may have a larger thickness than those of the third electrodes 9 and the auxiliary collector electrodes 10. The second electrodes 8 are required to have lower resistance because photogenerated carriers collected by the third electrodes 9 are collected to the second electrodes 8. Thus, each of the second electrodes 8 may have a larger thickness in addition to a larger line width to have lower resistance than those of other electrodes. In this case, each of the second electrodes 8 has a thickness of, for example, about 30 to about 60 µm. When the second electrodes 8 are formed simultaneously with the third electrodes 9 and the auxiliary collector electrodes 10 by a screen printing method, printing for forming portions to be formed into the second electrodes 8 may be performed multiple times in order to increase only the thickness of each of the second electrodes 8.

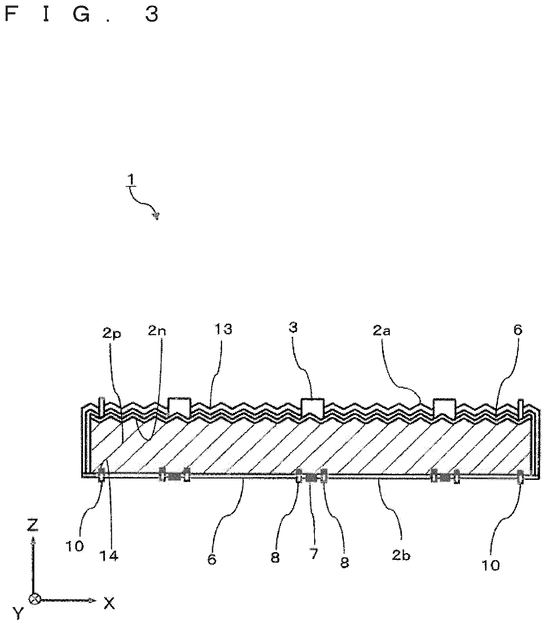

In this embodiment, spacer members 12 (contact members) are arranged on portions of the main surface of the semiconductor substrate 2 in the spaces 11. Specifically, the spacer members 12 are located on the main surface (the back surface 2b) of the semiconductor substrate 2 and in a line with the passivation layer 6 in one direction (the Y direction in this embodiment) in the spaces. In a cross section of the semiconductor substrate 2 in a second direction (the Z direction in Fig. 3) orthogonal to the back surface 2b, the spacer members 12 are higher than the first electrodes 7 in the second direction. The function of the spacer members 12 will be described below.

A conductive adhesive is arranged on surfaces of the first electrodes 7. The conductive adhesive is composed of solder.

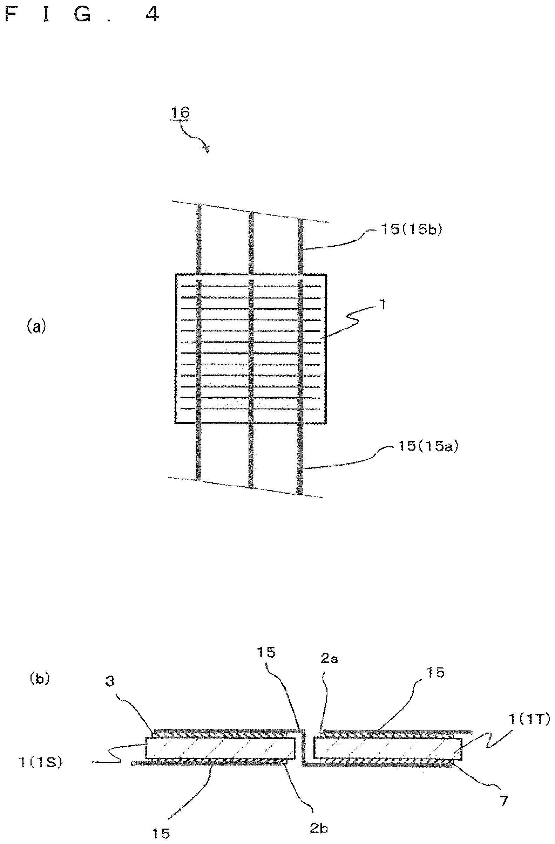

Neighboring two of the solar cell elements 1 are electrically connected to each other with the lead members 15 bonded to upper surfaces (surfaces) of the first electrodes 7 with the conductive adhesive, thereby resulting in the solar cell 1 as illustrated in Fig. 4(a). In the solar cell 16, lead members 15a are bonded (hereinafter, expressed as "soldered") to the busbar electrodes 3 on the light-receiving surface 2a of the solar cell element 1. Lead members 15b are soldered to the first electrodes 7 on the back surface 2b. The lead members 15 are arranged above the passivation layer 6.

Each of the lead members 15 is formed of, for example, metal foil having a strip shape and a thickness of about 0.1 to about 0.3 mm, the metal foil being composed of, for example, copper or aluminum. The metal foil is coated with solder corresponding to the conductive adhesive on its surface. The solder is arranged to a thickness of, for example, about 10 to about 50 µm. The lead members 15 may have a width equal to or smaller than that of the busbar electrodes 3. In this case, the lead members 15 are less likely to interfere with the reception of light. When the lead members 15 have larger width than that of the busbar electrodes 3, the lead members 15 have lower electrical resistance. Furthermore, when the lead members 15 have larger width than that of the busbar electrodes 3, the connection between the lead members 15 and the busbar electrodes 3 are maintained even if the lead members 15 are slightly misregistered with respect to the busbar electrodes 3. The lead members 15 may be connected to almost all surfaces of the busbar electrodes 3 and the first electrodes 7. This structure results in a reduction in the electrical resistance of the solar cell element 1. When two square solar cell elements 1 having a side of about 150 mm are connected to each other with the lead members 15, each of the lead members 15 may have a width of about 1 to about 3 mm and a length of about 260 to about 300 mm.

As illustrated in Fig. 4(b), neighboring two of the solar cell elements 1 (solar cell elements 1S and 1T) are connected together by soldering end portions of the lead members 15 bonded to the busbar electrodes 3 on the light-receiving surface 2a of the solar cell element 1S to the first electrodes 7 on the back surface 2b of the solar cell element 1T. The connecting operation is repeated for a plurality of the solar cell elements 1 (for example, about 5 to about 10 solar cell elements) to form solar cell strings in which the plural solar cell elements 1 (a plurality of the solar cells 16) are serially connected together in the form of a straight line.

The solder is mainly composed of, for example, tin (Sn) and lead (Pb). For example, a eutectic solder containing 60% to 63% by mass of tin and the balance being substantially lead is used. Substantially lead-free solders may be used. For example, a solder containing 90% to 97% by mass of tin and the balance being silver (Ag), copper (Cu), or the like may be used. Furthermore, a solder containing tin and zinc (Zn), bismuth (Bi), or indium (In) may be used.

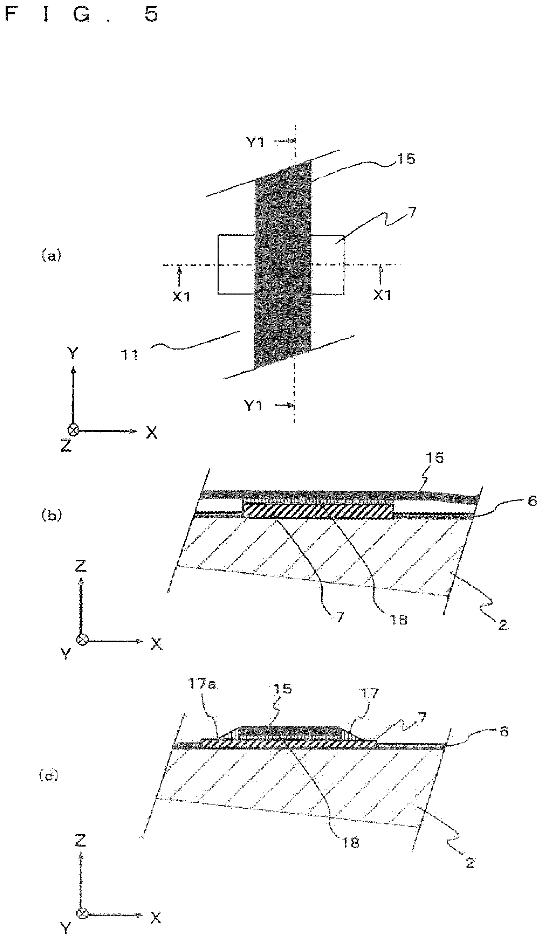

The function of the spacer members 12 will be described below. As illustrated in Figs. 5(a) to 5(c), when none of the spacer members 12 are arranged, layers of the conductive adhesive between the lead members 15 and the first electrodes 7 are easily reduced in thickness (hereinafter, description will be made by taking solder layers as an example). In this case, solder squeezed out from between the lead members 15 and the first electrodes 7 is liable to form large fillets 17 in the width direction of the lead members 15. When a solar cell module including the solar cells 16 with the fillets 17 is subjected to 1000 cycles or more of a temperature cycling test at a temperature of about +100°C to about -60°C, cracking occurs easily in portions of the first electrodes 7 directly below the fillets 17.

The occurrence of the cracking is seemingly caused by the following factors: End portions 17a of the fillets 17 are boundary portions between portions where solder is present and portions where solder is not present and thus are susceptible to stresses generated by the expansion and contraction of components due to the temperature cycling test. Thereby, the stresses seemingly concentrate on the portions of the first electrodes 7 located directly below the end portions 17a of the fillets 17 to cause cracking.

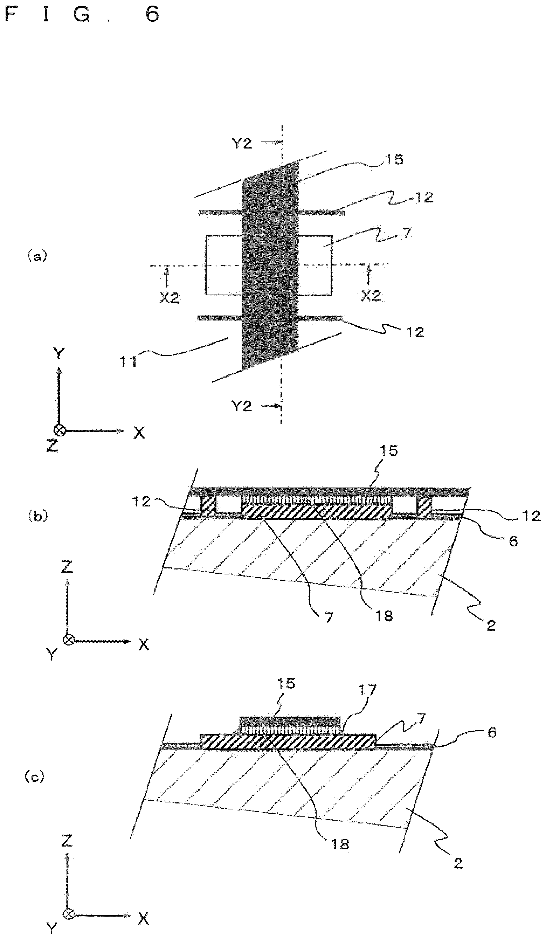

In contrast, when the spacer members 12 are arranged in the spaces 11 as in this embodiment, the lead members 15 are supported by the spacer members 12 each located between neighboring two of the first electrodes 7 as illustrated in Figs. 6(a) to 6(c). This is because the spacer members 12 serve as contact members in contact with a part of underside of each of the lead members 15. The spacer members 12 are higher than the first electrodes 7 in the Z direction, thus resulting in greater gaps between the lead members 15 and upper surfaces of the first electrodes 7. This leads to larger thickness of solder layers 18 between the lead members 15 and the first electrodes 7, thereby resulting in a smaller amount of solder squeezed out from between the lead members 15 and the first electrodes 7 to the side surfaces of the first electrodes 7 in the width direction of the lead members 15. Thus, the fillets 17 are less likely to be formed, reducing the stress concentration described above.

In the solar cell 16, cracking in the first electrodes 7 due to the fillets 17 is less likely to occur. Thereby, the solar cell is highly reliable. When the conductive adhesive has large thickness, the height of the spacer members 12 in the Z direction is the total of the height of the first electrodes 7 in the Z direction and the height of the conductive adhesive on the first electrodes 7 in the Z direction. However, the height (thickness) of the conductive adhesive is much smaller than that of the first electrodes 7. Thus, the height of the spacer members 12 only needs to be greater than that of the first electrodes 7.

Since solder is used as the conductive adhesive, the spacer members 12 contains aluminum as a main component. Solder is not easily bonded to aluminum, so that the lead members 15 are not easily bonded to the spacer members 12 with solder. Thus, the fillets 17 are less likely to be formed between the spacer members 12 and the lead members 15. When the spacer members 12 are composed of a material mainly containing aluminum, the spacer members 12 may be formed by, for example, screen printing in the same step of forming the second electrodes 8 and so forth.

The arrangement of the spacer members 12 is not limited to a layout in which one spacer member 12 is disposed in each space 11, and may be a layout in which two of the spacer members 12 are disposed at positions closer to neighboring two of the first electrodes 7, respectively. In this case, the gaps between the lead members 15 and the upper surfaces of the first electrodes 7 are more easily ensured.

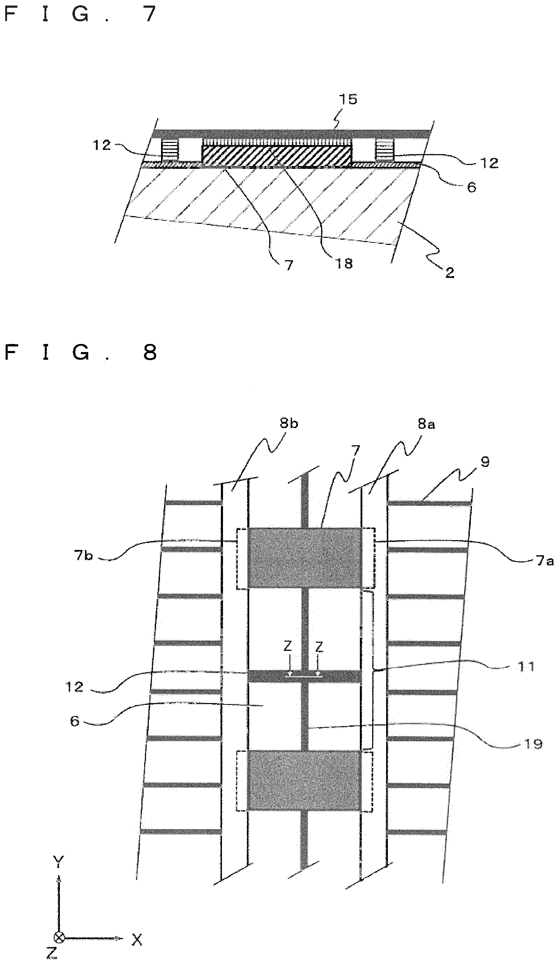

As illustrated in Fig. 7, the spacer members 12 may be arranged on the passivation layer 6 in the spaces 11. In this case, the area of the passivation layer 6 on the semiconductor substrate 2 is increased to enhance the passivation effect. This improves the photoelectric conversion efficiency of the solar cell element 1.

In this embodiment, fourth electrodes 19 each connected to neighboring two of the first electrodes 7 in a corresponding one of the spaces 11 may be arranged, as illustrated in Fig. 2. In this case, the fourth electrodes 19 are arranged in regions devoid of the passivation layer 6 and the spacer members 12 so as to be each connected to the neighboring two of the first electrodes 7 in the corresponding space 11. The fourth electrodes 19 are arranged so as to be in contact with the lead members 15. In this structure, even if one of the first electrodes 7 arranged in the same line is poorly connected to the corresponding lead member 15, carriers are conducted to another first electrode 7 with a good connection through the corresponding fourth electrode 19. This reduces an increase in the electrical resistance of the solar cell 16. Each of the fourth electrodes 19 may have a line width of about 0.1 to about 1 mm in the X direction and a thickness of about 2 to about 12 µm. The fourth electrodes 19 may be composed of a material equivalent to the material of the first electrodes 7 and may be formed by a method equivalent to a method for producing the first electrodes 7. Two fourth electrodes 19 may be arranged on both end portion sides of each first electrode 7 in the X direction. Three fourth electrodes 19 may be arranged on both the end portion sides and the central portion of each first electrode 7 in the X direction. The number of the fourth electrodes 19 is not particularly limited and may be one to three in order to ensure the region of the passivation layer 6. When the spacer members 12 are formed of insulating members composed of, for example, a resin, the fourth electrodes 19 are arranged on the spacer members 12 at intersection points of the spacer members 12 and the fourth electrodes 19. In this case, the fourth electrodes 19 are arranged so as to be in contact with the lead members 15, so that carriers collected by the fourth electrodes 19 are directly connected to the lead members 15.

In this embodiment, each of the first electrodes 7 includes a first side surface 7a and a second side surface 7b opposite the first side surface 7a, as illustrated in Fig. 8. The second electrodes 8 include a first portion 8a connected to the first side surfaces 7a of neighboring two of the first electrodes 7 and a second portion 8b connected to the second side surfaces 7b of the neighboring two of the first electrodes 7.

The first portion 8a of the second electrodes 8 is electrically connected to the first side surfaces 7a of the neighboring two of the first electrodes 7 in the Y direction. The first portion 8a may be arranged so as to partially cover end portions of the first electrodes 7 in the vicinity of the first side surfaces 7a of the first electrodes 7 in the X direction. This structure results in a lower contact resistance and a strong connection between the first electrodes 7 and the second electrodes 8.

The second portion 8b of the second electrodes 8 is electrically connected to the second side surfaces 7b of the neighboring two of the first electrodes 7 in the Y direction. The second portion 8b may be arranged so as to partially cover end portions of the first electrodes 7 in the vicinity of the second side surfaces 7b of the first electrodes 7 in the X direction. This structure results in a lower contact resistance between the first electrodes 7 and the second electrodes 8. In this embodiment, this structure also results in a strong connection between the first electrodes 7 and the second electrodes 8.

When the spacer members 12 are electrically conductive, the spacer members 12 may be arranged so as to be connected to the second electrode 8a and the second electrode 8b. In this case, the second electrode 8a and the second electrode 8b are electrically connected to each other with the spacer members 12. In other words, the spacer members 12 are connected to the two second electrodes 8 in the spaces 11. In this structure, the spacer members 12 may be used as electrical detours even if a crack is formed in a portion of the first electrodes 7 adjacent to the first side surface 7a or the second side surface 7b, thereby reducing an increase in resistance. In this case, the spacer members 12 may be composed of, for example, the same material as that of the second electrodes 8, the third electrodes 9, or the auxiliary collector electrodes 10. Specifically, the spacer members 12 may be the same electrically conductive material as that of the second electrodes 8 and the third electrodes 9. In this case, the auxiliary collector electrodes 10 may be composed of the same material as that of the spacer members 12, thereby leading to the simplification of the process. Each of the spacer members 12 may have a width of about 0.2 to about 2 mm and a thickness of about 30 to about 60 µm.

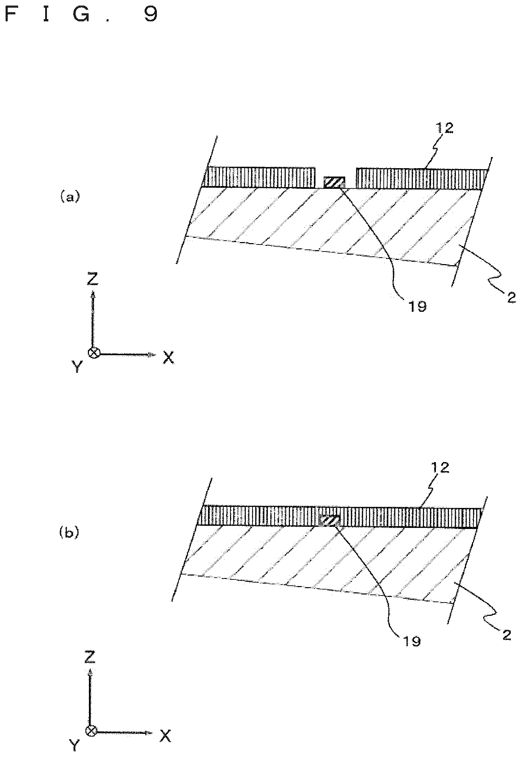

Relative positions between the spacer members 12 and the fourth electrodes 19 will be described below. As illustrated in Fig. 9(a), the fourth electrode 19 may be arranged in a region devoid of the passivation layer 6 and the spacer member 12, the region being connected to neighboring two of the first electrodes 7 in the space 11. In this case, as illustrated in Fig. 9(a), a portion of the spacer member 12 corresponding to an intersection point of the spacer member 12 and the fourth electrode 19 may be partially cut out. That is, the spacer member 12 may not come into contact with the fourth electrode 19. In this case, the thickness (height in the Z direction) of the fourth electrodes 19 does not affect the spacer members 12, thus easily ensuring the height between the first electrodes 7 and the lead members 15.

As illustrated in Fig. 9(b), the fourth electrode 19 may be arranged in a region devoid of the passivation layer 6, the region being connected to neighboring two of the first electrodes 7 in the space 11. As illustrated in Fig. 9(b), the spacer member 12 may be arranged on the fourth electrode 19. In this embodiment, the fourth electrodes 19 may be arranged on portions of the back surface 2b of the semiconductor substrate 2 corresponding to the spaces 11. Thus, even if the fourth electrodes are thinly formed, a break is less likely to occur.

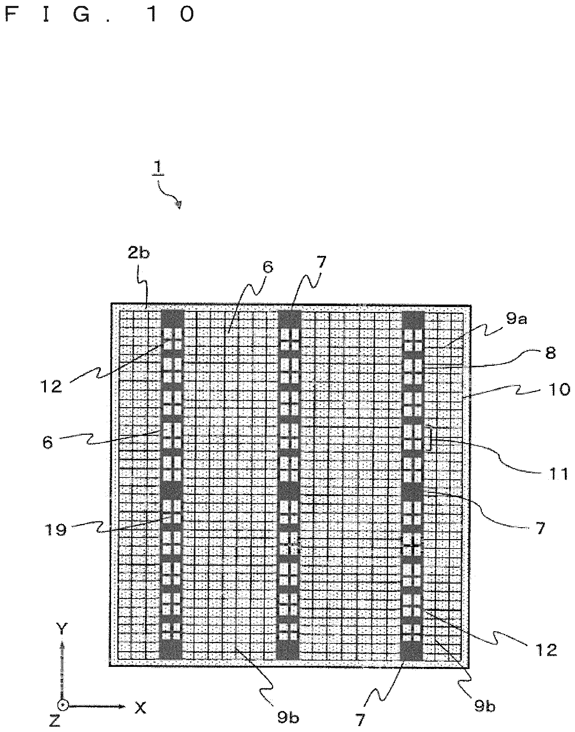

In the solar cell 16 illustrated in Fig. 10, the third electrodes 9 of the solar cell element 1 may include a grid pattern. The third electrodes 9 include third electrodes 9a extending in a third direction (the X direction in Fig. 7) and third electrodes 9b extending in the first direction (the Y direction). The third electrodes 9a and the third electrodes 9b are connected together at a plurality of intersection points. When the third electrodes 9 are used, even if any one of the first electrodes 7 is poorly connected to the corresponding lead member 15, carriers are conducted to another first electrode 7 through the third electrodes 9a and the third electrodes 9b. This reduces an increase in resistance. The third electrodes 9a and the third electrodes 9b may have a line width of about 100 to about 500 µm and a thickness of about 15 to about 40 µm. The third electrodes 9a are arranged at intervals of about 1 to about 6 mm. The third electrodes 9b are also arranged at intervals of about 1 to about 6 mm.

### <Method for producing solar cell>

A method for producing the solar cell 16 will be described below.

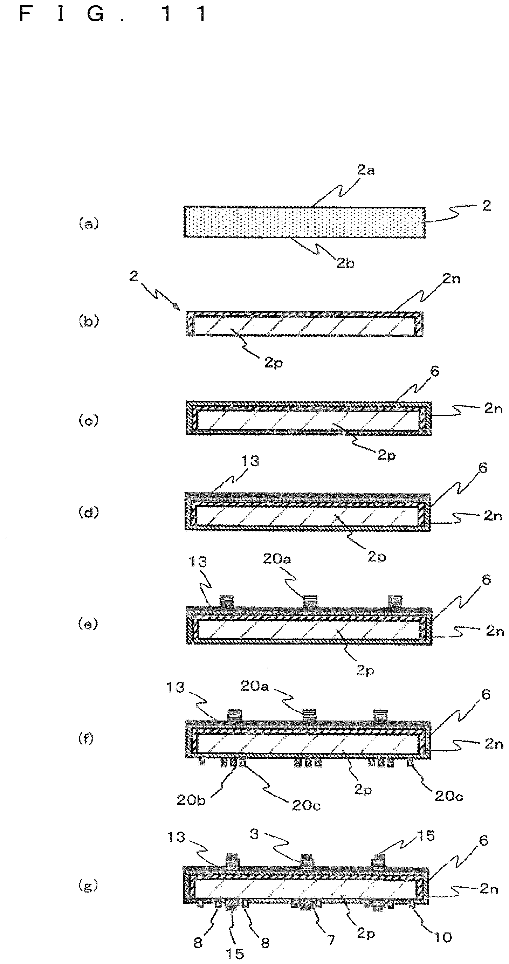

As illustrated in Fig. 11(a), the semiconductor substrate 2 including a layer with a conductivity type is prepared. As the semiconductor substrate 2, a semiconductor substrate with a first conductivity type may be used. Specifically, a p-type silicon substrate containing a dopant, such as boron, may be used. The silicon substrate is composed of single-crystal or polycrystalline silicon. The silicon substrate preferably has a resistivity of about 0.2 to about 2 Ω·cm. The silicon substrate may be in the form of a square or rectangle with a side of, for example, about 140 to about 180 mm and may have a thickness of about 100 µm to about 250 µm. When the semiconductor substrate 2 is composed of single-crystal silicon, the semiconductor substrate 2 is produced by, for example, a floating zone (FZ) method or a Czochralski (CZ) method. When the semiconductor substrate 2 is composed of polycrystalline silicon, a polycrystalline silicon ingot is produced by, for example, a casting method, and then the ingot is sliced into the semiconductor substrate 2 with a predetermined thickness. Descriptions will be given below by taking a p-type polycrystalline silicon substrate as an example.

Preferably, surfaces of the semiconductor substrate 2 are lightly etched with, for example, a solution of NaOH, a solution of KOH, or a solution of hydrofluoric acid and nitric acid in order to remove a mechanically damaged layer and a contamination layer on a cut surface. After this etching step, a fine irregular structure (texture) is preferably formed on the light-receiving surface 2a of the semiconductor substrate 2 by a wet etching method or a dry etching method, such as a reactive ion etching (RIE) method. This reduces optical reflectivity of the light-receiving surface 2a to improve the photoelectric conversion efficiency of the solar cell 1.

As illustrated in Fig. 11(b), the n-type second semiconductor portion 2n is formed on the first semiconductor portion 2p of the semiconductor substrate 2 adjacent to the light-receiving surface 2a. The second semiconductor portion 2n is formed by diffusing an n-type impurity (for example, phosphorus) into a surface layer adjacent to the light-receiving surface 2a. Examples of a method of diffusion include an application and thermal diffusion process in which phosphorus pentoxide (P₂O₅) in the form of a paste is applied to a surface of the semiconductor substrate 2 and thermally diffused; a vapor-phase thermal diffusion process in which gaseous phosphorus oxychloride (POCl₃) is used as a diffusion source; and an ion implantation process in which phosphorus ions are directly diffused. The second semiconductor portion 2n is formed so as to have a thickness of, for example, about 0.1 to about 1 µm and a sheet resistance of about 40 to about 150 Ω/□. When an opposite conductivity-type layer is formed on the back surface 2b side in forming the second semiconductor portion 2n, only the back surface 2b side is removed by etching to expose a p-type conductivity region. In this etching step, for example, only the back surface 2b side of the semiconductor substrate 2 is dipped in a solution of hydrofluoric acid and nitric acid, thereby removing the second semiconductor portion 2n on the back surface 2b side. The second semiconductor portion 2n may be formed by, for example, a vapor-phase thermal diffusion process with a diffusion preventing mask composed of silicon oxide or the like, the diffusion preventing mask having been formed on the back surface 2b side in advance.

As illustrated in Fig. 11(c), the passivation layer 6 is formed on almost all areas of both surfaces of the semiconductor substrate 2 on the light-receiving surface 2a side and the back surface 2b side. The passivation layer 6 may be simultaneously formed on all surfaces of the semiconductor substrate 2 by, for example, an ALD method. A method for forming the passivation layer 6 composed of aluminum oxide by the ALD method will be described below.

The semiconductor substrate 2 is placed in a film formation chamber. The substrate temperature is increased to 100°C to 300°C by heating. An aluminum source, such as trimethylaluminum, is fed onto the semiconductor substrate 2 for 0.1 to 1 second with a carrier gas, for example, argon gas or nitrogen gas, to allow the aluminum source to be adsorbed on the entire surfaces of the semiconductor substrate 2 (PS step 1).

The firm formation chamber is purged with nitrogen gas for 0.5 to 3 seconds to remove the aluminum source in a space and the aluminum source adsorbed on the semiconductor substrate 2 other than components adsorbed on the semiconductor substrate 2 at an atomic layer level (PS step 2) .

An oxidizing agent, for example, water or ozone gas, is fed into the film formation chamber for 1 to 8 seconds to remove the alkyl (CH₃) groups of trimethylaluminum serving as the aluminum source and to oxidize dangling bonds of aluminum. This results in the formation of an atomic layer of aluminum oxide on the semiconductor substrate 2 (PS step 3) .

The film formation chamber is purged with nitrogen gas for 0.5 to 5 seconds to remove the oxidizing agent in the space (PS step 4). At this time, components, for example, the oxidizing agent that has not contributed to the reaction, other than aluminum oxide present in the atomic layer level are also removed.

Repeating PS steps 1 to 4 results in the formation of the passivation layer 6 having a predetermined thickness. By incorporating hydrogen into the oxidizing agent used in the PS step 3, the aluminum oxide layer easily contains hydrogen. This increases the effect of hydrogen passivation.

The use of the ALD method results in the formation of the aluminum oxide layer in response to the fine irregularities on the surface of the semiconductor substrate 2. This enhances the effect of surface passivation.

As illustrated in Fig. 11(d), the antireflection film 13 is formed on the passivation layer 6 on the side of the light-receiving surface 2a of the semiconductor substrate 2. The antireflection film 13 is formed by forming a film composed of, for example, silicon nitride, titanium oxide, silicon oxide, or aluminum oxide, using, for example, a PECVD method, a thermal CVD method, an evaporation method, or a sputtering method. For example, when the antireflection film 13 formed of a silicon nitride film is formed by the PECVD method, the antireflection film 13 is formed by setting the inside temperature of a reaction chamber to about 450°C to about 550°C, diluting a gas mixture of silane (SiH₄) and ammonia (NH₃) with nitrogen (N₂), forming the gas mixture into plasmas by glow discharge decomposition, and depositing the plasmas.

As illustrated in Fig. 11(e), the application of a conductive paste 20a is performed for the formation of electrodes (the busbar electrodes 3, the collector electrodes 4, and the auxiliary collector electrodes 5) on the side of the light-receiving surface. The electrodes on the side of the light-receiving surface are formed with the conductive paste 20a containing a conductive component that contains at least one of silver and copper, a glass frit, and an organic vehicle. The conductive paste 20a contains at least one of silver and copper as a main component. The organic vehicle is prepared by, for example, dissolving a resin component serving as a binder in an organic solvent. Examples of the binder used include cellulosic resins, such as ethyl cellulose; acrylic resins; and alkyd resins. Examples of the organic solvent used include terpineol and diethylene glycol monobutyl ether. The content by mass of the organic vehicle may be about 6 parts by mass or more and about 20 parts by mass or less with respect to the total mass (100 parts by mass) of the conductive component, such as silver. Regarding components of the glass frit, as a glass material, a lead-based glass, for example, a SiO₂-Bi₂O₃-PbO-based glass or an Al₂O₃-SiO₂-PbO-based glass, may be used. In addition, a lead-free glass, for example, a B₂O₃-SiO₂-Bi₂O₃-based glass or a B₂O₃-SiO₂-ZnO-based glass, may be used. The content by mass of the glass frit may be about 2 parts by mass or more and about 13 parts by mass with respect to the total mass (100 parts by mass) of the conductive component, such as silver. The conductive paste 20a is applied by, for example, a screen printing method to the antireflection film 13 on the light-receiving surface 2a of the semiconductor substrate 2.

As illustrated in Fig. 11(f), a conductive paste for the first electrodes 7, the second electrodes 8, the third electrodes 9, and the auxiliary collector electrodes 10 serving as back-surface-side electrodes is applied to the passivation layer 6. Simultaneously, a conductive paste for the spacer members 12 is applied. Regarding the order of the application, first, a conductive paste 20b for the formation of the first electrodes 7 is applied. As the conductive paste used, the same conductive paste as that used in the formation of the electrodes on the side of the light-receiving surface 2a may be used. The application is performed by a screen printing method.

Next, a conductive paste 20c for the formation of the second electrodes 8, the third electrodes 9, the auxiliary collector electrodes 10, and the spacer members 12 is applied. The conductive paste for the formation of these electrodes and the spacer members 12 is formed of a paste containing a metal powder that contains aluminum as a main component, a glass frit, and an organic vehicle. The metal powder may have an average particle diameter of about 3 to about 20 µm. The organic vehicle is a binder dissolved in an organic solvent. As the glass frit, for example, a SiO₂-Pb-based, SiO₂-B₂O₃-PbO-based, or Bi₂O₃-SiO₂-B₂O₃-based glass frit may be used. For example, the aluminum paste may have a composition of 60% by mass or more and 85% by mass or less of an aluminum powder, 5% by mass or more and 25% by mass or less of the organic vehicle, and 0.1% by weight or more and 10% by weight or less of the glass frit with respect to the total mass of the aluminum paste. To reduce the warping and the resistivity of the semiconductor substrate 2 after firing, for example, zinc oxide (ZnO), silicon oxide (SiO₂), or aluminum oxide (Al₂O₃) may be added.

Subsequently, the semiconductor substrate 2 to which the conductive pastes have been applied is fired at a peak temperature of 600°C to 800°C for several tens of seconds to several tens of minutes to form the electrodes and the spacer members 12, thereby producing the solar cell element 1 as illustrated in Figs. 1 to 3. In this case, the electrodes on the back surface side and the spacer members 12 pass through the passivation layer 6 and are formed on the back surface 2b of the semiconductor substrate 2. The electrodes on the back surface side and the spacer members 12 may be formed so as not to pass through the passivation layer 6. In this case, the compositions of the conductive pastes may be changed, and the firing temperature may be lowered.

As illustrated in Fig. 11(g), the lead members 15 are connected to the busbar electrodes 3 and the first electrodes 7 of the solar cell element 1. In this case, the connection may be performed by arranging the lead members 15 coated with solder serving as a conductive adhesive on the first electrodes 7 and bringing a soldering iron into contact with the lead members 15. Instead of the soldering iron, the solder may be melted by hot-air blowing to connect the lead members 15 to the first electrodes 7 and the busbar electrodes 3. The first electrodes 7 and the lead members 15 may be soldered together by laser irradiation. Next, the solar cell element 1 is reversed. The lead members 15 are arranged on the busbar electrodes 3. Soldering is performed in the same way as above. Thereby, the solar cell 16 is produced.

The structure of the solar cell element and the solar cell and the method for producing the solar cell element and the solar cell are not limited to the foregoing description. Various changes and modifications can be made without departing from the scope of the invention. For example, the passivation layer 6 may be arranged only on the back surface 2b of the semiconductor substrate 2.

### <Solar cell module>

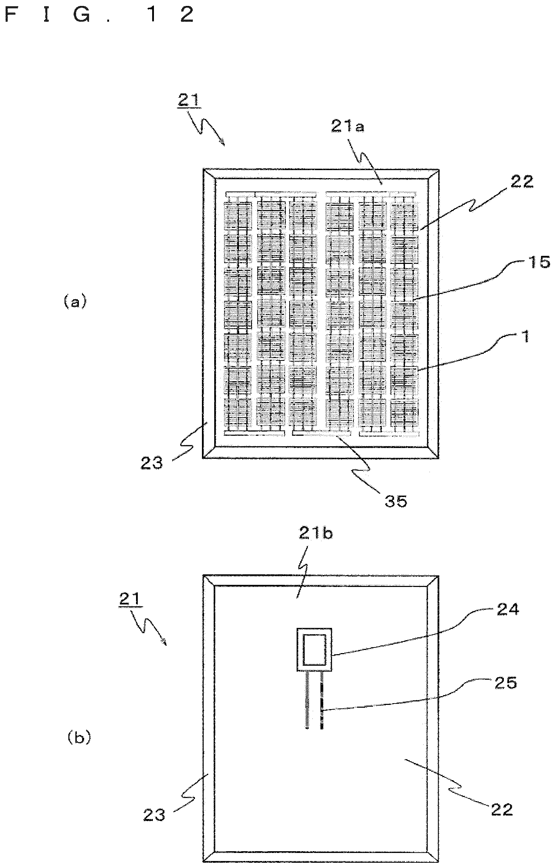

As illustrated in Fig. 12(a), a solar cell module 21 according to an embodiment of the present invention includes a first surface 21a mainly serving as a light-receiving surface; and a second surface 21b corresponding to the backside of the first surface 21a as illustrated in Fig. 12(b). As illustrated in Figs. 12(a) and 12(b), the solar cell module 21 includes a solar cell panel 22 including a plurality of the solar cells 16; a frame 23 arranged at an outer peripheral portion of the solar cell panel 22; and a terminal box 24 and so forth on the second surface 21b side. The terminal box 24 is connected to output cables 25 configured to supply an external circuit with electric power generated by the solar cell module 21.

The solar cell panel 22 includes the plural solar cells 16, a transparent substrate 31, a front-side filling material 32, a back-side filling material 33, a back-side material 34, transverse leads 35, and extraction leads 36.

As the transparent substrate 31, a substrate composed of, for example, glass or a polycarbonate resin is used. In the case of the glass, for example, white tempered glass, double-tempered glass, or heat-reflecting glass is used. In the case of a resin, a synthetic resin, such as a polycarbonate resin, is used. The transparent substrate 31 composed of white tempered glass may have a thickness of about 3 to about 5 mm.

The front-side filling material 32 and the back-side filling material 33 contain an enthylene-vinyl acetate copolymer (hereinafter, abbreviated as "EVA"), polyvinyl butyral (PVB), or the like. EVA and PVB are formed into sheets each having a thickness of about 0.4 to about 1 mm before use. The sheets are heated and pressed under reduced pressure with a laminating apparatus, so that the sheets are bonded to other members by fusion.

The back-side material 34 serves to inhibit the penetration of water from the outside. For the back-side material 34, for example, a weatherproof fluorine-containing resin sheet including aluminum foil held therein or a polyethylene terephthalate (PET) sheet containing alumina or silica deposited thereon is used. When light incident on the second surface 21b side of the solar cell module 21 is used for electric power generation, the back-side material 34 may be composed of, for example, glass or a polycarbonate resin.

The solar cell panel 22 includes solar cell strings each including a plurality of the solar cells 16 electrically connected together. The plural solar cell strings are arranged in an almost parallel matter at predetermined intervals of about 1 to about 10 mm. The solar cells 16 located at end portions of the solar cell strings are connected to each other by, for example, soldering with the transverse leads 35. The extraction leads 36 are connected to the solar cell elements 1 located at end portions of the solar cell strings that lie at both ends of the solar cell panel 22, the solar cell elements 1 being not connected to the transverse leads 35.

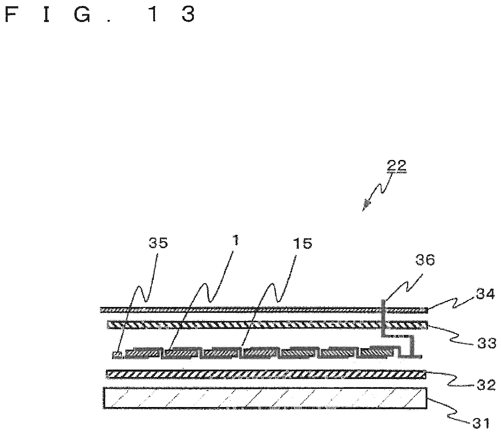

The solar cell panel 22 is produced as follows: As illustrated in Fig. 13, after the front-side filling material 32 is arranged on the transparent substrate 31, the solar cells 16 connected to form the solar cell strings, the back-side filling material 33, the back-side material 34, and so forth are sequentially stacked to form a stack. The stack is placed in a laminating apparatus and heated under reduced pressure at 100°C to 200°C for, for example, about 15 minutes to about 1 hour with the stack pressed, thereby producing the solar cell panel 22.

The frame 23 is arranged to the outer peripheral portion of the solar cell panel 22. The terminal box 24 is attached to the second surface 21b to complete the solar cell module 21 illustrated in Fig. 12.

Even when the solar cell module 21 is placed in an outdoor location and used in an outdoor environment over long periods of time, a reduction in photoelectric conversion efficiency is suppressed because the solar cell module 21 includes the foregoing solar cells 16. That is, the solar cell module 21 is highly reliable.

### Reference Signs List

1: solar cell element
2: semiconductor substrate
2a: light-receiving surface
2b: back surface
2p: first semiconductor portion
2n: second semiconductor portion
3: busbar electrode
4: collector electrode
5: auxiliary collector electrode
6: passivation layer
7: first electrode
7a: first side surface
7b: second side surface
8: second electrode
8a: first portion
8b: second portion
9: third electrode
10: auxiliary collector electrode
11: space
12: spacer member (contact member)
13: antireflection film
14: BSF layer
15, 15a, 15b: lead member
16: solar cell
17: fillet
18: solder layer
19: fourth electrode
20a: to 20c: conductive paste
21: solar cell module
21a: first surface
21b: second surface
22: solar cell panel
23: frame
24: terminal box
25: output cable
31: transparent substrate
32: front-side filling material
33: back-side filling material
34: back-side material
35: transverse lead
36: extraction lead

## Claims

1. A solar cell comprising:
a semiconductor substrate (2) comprising a main surface (2b) ;
a plurality of first electrodes (7) lining up in one direction on the main surface (2b) of the semiconductor substrate (2), each comprising an upper surface and side surfaces;
a passivation layer (6) disposed in a space (11) between the first electrodes (7) on the main surface (2b) of the semiconductor substrate (2);
a conductive adhesive (18) on the upper surface of each of the first electrodes (7);
a lead member (15) above the passivation layer (6), connected to neighboring two of the first electrodes (7) with the conductive adhesive (18); and
a contact member (12) located in the space (11), lining up with the passivation layer (6) in the one direction on the main surface (2b) of the semiconductor substrate (2) or being arranged on the passivation layer (6), and being in contact with a part of underside of the lead member (15), wherein
the contact member (12) is higher than the first electrodes (7) in a direction orthogonal to the main surface (2b),
the conductive adhesive (18) is composed of solder, and
the contact member (12) contains aluminum as a main component.

2. The solar cell according to claim 1, further comprising:
two second electrodes (8) on the main surface (2b) of the semiconductor substrate (2) along two sides of the first electrodes (7), each connected to side surfaces of the first electrodes (7),
wherein the contact member (12) is electrically conductive and is connected to the two second electrodes (8) in the space (11).

3. The solar cell (1) according to claim 1 or 2, further comprising:
a third electrode (9) on the main surface (2b) of the semiconductor substrate (2), connected to the second electrodes (8) and extending outward.

4. The solar cell according to claim 3, wherein the third electrode (9) comprises a grid pattern on the main surface (2b) of the semiconductor substrate (2).

5. The solar cell according to claim 3 or 4, wherein the second electrodes (8), the third electrode (9), and the contact member (12) are composed of a same conductive material.

6. The solar cell according to any one of claims 1 to5, further comprising:
a region being:
devoid of the passivation layer (6) and the contact member (12); and
connected to the neighboring two of the first electrodes (7) in the space (11); and
a fourth electrode (19) in the region, connected to the neighboring two of the first electrodes (7).

7. The solar cell according to any one of claims 2 to 5, further comprising:
a region being:
devoid of the passivation layer (6); and
connected to the neighboring two of first electrodes (7) in the space (11); and
a fourth electrode (19) connected to the neighboring two of first electrodes (7) and the contact member (12) in the region.

8. The solar cell according to claim 7, wherein a portion of the contact member (12) is located on the fourth electrode (19).

9. A solar cell module (21) comprising a solar cell panel (22) that comprises a plurality of the solar cells according to any one of claims 1 to 8, the solar cells electrically connected together.

## Patentansprüche

1. Eine Solarzelle, aufweisend:
ein Halbleitersubstrat (2), das eine Hauptfläche (2b) aufweist,
eine Mehrzahl von ersten Elektroden (7), die in einer Richtung auf der Hauptfläche (2b) des Halbleitersubstrats (2) aufgereiht sind, wobei jede eine obere Fläche und Seitenflächen aufweist,
eine Passivierungsschicht (6), die in einem Raum (11) zwischen den ersten Elektroden (7) auf der Hauptfläche (2b) des Halbleitersubstrats (2) angeordnet ist,
ein leitfähiges Haftmittel (18) auf der oberen Fläche von jeder der ersten Elektroden (7),
ein Leitungselement (15) über der Passivierungsschicht (6), das mit dem leitfähigen Haftmittel (18) mit zwei benachbarten der ersten Elektroden (7) verbunden ist, und
ein Kontaktelement (12), das sich in dem Raum (11) befindet, das mit der Passivierungsschicht (6) in der einen Richtung auf der Hauptfläche (2b) des Halbleitersubstrats (2) aufgereiht ist oder auf der Passivierungsschicht (6) angeordnet ist und das in Kontakt mit einem Teil der Unterseite des Leitungselements (15) ist, wobei
das Kontaktelement (12) in einer Richtung orthogonal zu der Hauptfläche (2b) höher als die ersten Elektroden (7) ist,
das leitfähige Haftmittel (18) aus Lötmittel zusammengesetzt ist und
das Kontaktelement (12) Aluminium als einen Hauptbestandteil enthält.

2. Die Solarzelle gemäß Anspruch 1, ferner aufweisend:
zwei zweite Elektroden (8) auf der Hauptfläche (2b) des Halbleitersubstrats (2) entlang zwei Seiten der ersten Elektroden (7), von denen jede mit Seitenflächen der ersten Elektroden (7) verbunden ist,
wobei das Kontaktelement (12) elektrisch leitfähig ist und mit den zwei zweiten Elektroden (8) im Raum (11) verbunden ist.

3. Die Solarzelle (1) gemäß Anspruch 1 oder 2, ferner aufweisend:
eine dritte Elektrode (9) auf der Hauptfläche (2b) des Halbleitersubstrats (2), die mit den zweiten Elektroden (8) verbunden ist und sich nach außen erstreckt.

4. Die Solarzelle gemäß Anspruch 3, wobei die dritte Elektrode (9) ein Raster auf der Hauptfläche (2b) des Halbleitersubstrats (2) aufweist.

5. Die Solarzelle gemäß Anspruch 3 oder 4, wobei die zweiten Elektroden (8), die dritte Elektrode (9) und das Kontaktelement (12) aus einem gleichen leitfähigen Material zusammengesetzt sind.

6. Die Solarzelle gemäß irgendeinem der Ansprüche 1 bis 5, ferner aufweisend:
einen Bereich, der:
frei von der Passivierungsschicht (6) und dem Kontaktelement (12) ist und
mit den benachbarten zwei der ersten Elektroden (7) in dem Raum (11) verbunden ist, und
eine vierte Elektrode (19) in dem Bereich, die mit den benachbarten zwei der ersten Elektroden (7) verbunden ist.

7. Die Solarzelle gemäß irgendeinem der Ansprüche 2 bis 5, ferner aufweisend:
einen Bereich, der:
frei von der Passivierungsschicht (6) ist und
mit den benachbarten zwei von ersten Elektroden (7) in dem Raum (11) verbunden ist, und
eine vierte Elektrode (19), die mit den benachbarten zwei von ersten Elektroden (7) und dem Kontaktelement (12) in dem Bereich verbunden ist.

8. Die Solarzelle gemäß Anspruch 7, wobei ein Abschnitt des Kontaktelements (12) auf der vierten Elektrode (19) angeordnet ist.

9. Ein Solarzellenmodul (21), aufweisend ein Solarzellenpaneel (22), das eine Mehrzahl der Solarzellen gemäß irgendeinem der Ansprüche 1 bis 8 aufweist, wobei die Solarzellen elektrisch miteinander verbunden sind.

## Revendications

1. Une cellule solaire, comportant :
un substrat semi-conducteur (2) comportant une surface principale (2b),
une pluralité de premières électrodes (7) s'alignant dans une direction sur la surface principale (2b) du substrat semi-conducteur (2), chacune comportant une surface supérieure et des surfaces latérales,
une couche de passivation (6) disposée dans un espace (11) entre les premières électrodes (7) sur la surface principale (2b) du substrat semi-conducteur (2),
un adhésif conducteur (18) sur la surface supérieure de chacune des premières électrodes (7),
un élément de conduite (15) au-dessus de la couche de passivation (6), relié à deux adjacentes des premières électrodes (7) avec l'adhésif conducteur (18), et
un élément de contact (12) disposé dans l'espace (11), s'alignant avec la couche de passivation (6) dans ladite une direction sur la surface principale (2b) du substrat semi-conducteur (2) ou étant disposé sur la couche de passivation (6), et étant en contact avec une partie du dessous de l'élément de conduite (15), où
l'élément de contact (12) est plus élevé que les premières électrodes (7) dans une direction orthogonale à la surface principale (2b),
l'adhésif conducteur (18) est composé de soudure, et
l'élément de contact (12) contient de l'aluminium comme composant principal.

2. La cellule solaire selon la revendication 1, comportant en outre :
deux deuxièmes électrodes (8) sur la surface principale (2b) du substrat semi-conducteur (2) le long de deux côtés des premières électrodes (7), chacune reliée à des surfaces latérales des premières électrodes (7),
où l'élément de contact (12) est électriquement conducteur et est relié aux deux deuxièmes électrodes (8) dans l'espace (11).

3. La cellule solaire (1) selon la revendication 1 ou 2, comportant en outre :
une troisième électrode (9) sur la surface principale (2b) du substrat semi-conducteur (2), reliée aux deuxièmes électrodes (8) et s'étendant vers l'extérieur.

4. La cellule solaire selon la revendication 3, dans laquelle la troisième électrode (9) comprend un motif de grille sur la surface principale (2b) du substrat semi-conducteur (2).

5. La cellule solaire selon la revendication 3 ou 4, dans laquelle les deuxièmes électrodes (8), la troisième électrode (9) et l'élément de contact (12) sont composés du même matériau conducteur.

6. La cellule solaire selon l'une quelconque des revendications 1 à 5, comportant en outre :
une région étant :
dépourvue de la couche de passivation (6) et de l'élément de contact (12), et
reliée aux deux adjacentes des premières électrodes (7) dans l'espace (11), et
une quatrième électrode (19) dans la région, reliée aux deux adjacentes des premières électrodes (7).

7. La cellule solaire selon l'une quelconque des revendications 2 à 5, comportant en outre :
une région étant :
dépourvue de la couche de passivation (6), et
reliée aux deux adjacentes de premières électrodes (7) dans l'espace (11), et
une quatrième électrode (19) reliée aux deux adjacentes de premières électrodes (7) et de l'élément de contact (12) dans la région.

8. La cellule solaire selon la revendication 7, dans laquelle une partie de l'élément de contact (12) est disposée sur la quatrième électrode (19).

9. Un module de cellule solaire (21) comportant un panneau de cellules solaires (22) qui comprend une pluralité des cellules solaires selon l'une quelconque des revendications 1 à 8, les cellules solaires étant reliées électriquement les unes aux autres.
